# FASCICULE DE BREVET EUROPEEN

(11) **EP 3 091 572 B1**
(45) Date de publication et mention de la délivrance du brevet: **30.10.2019**
(21) Numéro de dépôt: 15193789.3
(22) Date de dépôt: 10.11.2015
(51) Int. Cl.: H01L 25/07, H01L 29/10, H01L 29/747, H01L 27/082

(54) **COMMUTATEUR BIDIRECTIONNEL DE PUISSANCE**
BIDIREKTIONELLER LEISTUNGSSCHALTER
BIDIRECTIONAL POWER SWITCH

(30) Priorité: 05.05.2015 FR 1554010
(43) Date de publication de la demande: 09.11.2016
(73) Titulaire: STMicroelectronics (Tours) SAS, 37100 Tours (FR)
(72) Inventeur: HAGUE, Yannick, 37390 Mettray (FR)
(74) Mandataire: Cabinet Beaumont

(56) Documents cités:
- WO-A1-02/50916
- JP-A- S58 134 471
- US-A1- 2003 057 480
- RIZK HIBA ET AL: "A vertical bidirectional bipolar power switch (BipAC) for AC mains applications", 2014 16TH EUROPEAN CONFERENCE ON POWER ELECTRONICS AND APPLICATIONS, IEEE, 26 août 2014 (2014-08-26), pages 1-10, XP032651193, DOI: 10.1109/EPE.2014.6910942

## Description

### Domaine

La présente demande concerne un commutateur bidirectionnel de puissance.

### Exposé de l'art antérieur

De nombreux types de commutateurs bidirectionnels de puissance ont déjà été proposés. De tels commutateurs sont par exemple utilisés connectés en série avec une charge à alimenter entre des bornes de fourniture d'une tension alternative d'alimentation (par exemple la tension secteur), pour contrôler la puissance fournie à la charge.

Parmi les commutateurs bidirectionnels de puissance connus, on peut notamment citer les triacs, très répandus, qui présentent l'avantage d'être relativement bon marché. Une limitation du triac est toutefois que sa borne de commande permet uniquement de le commander de l'état bloqué à l'état passant, le passage de l'état passant à l'état bloqué se produisant naturellement lorsque le courant traversant le triac descend en dessous d'un seuil.

Diverses solutions à base de transistors MOS ou bipolaires ont en outre été proposées pour réaliser des commutateurs bidirectionnels de puissance commandables à l'état fermé et à l'état ouvert. Ces commutateurs sont toutefois relativement coûteux. En outre, la commande de ces commutateurs peut nécessiter des circuits relativement complexes.

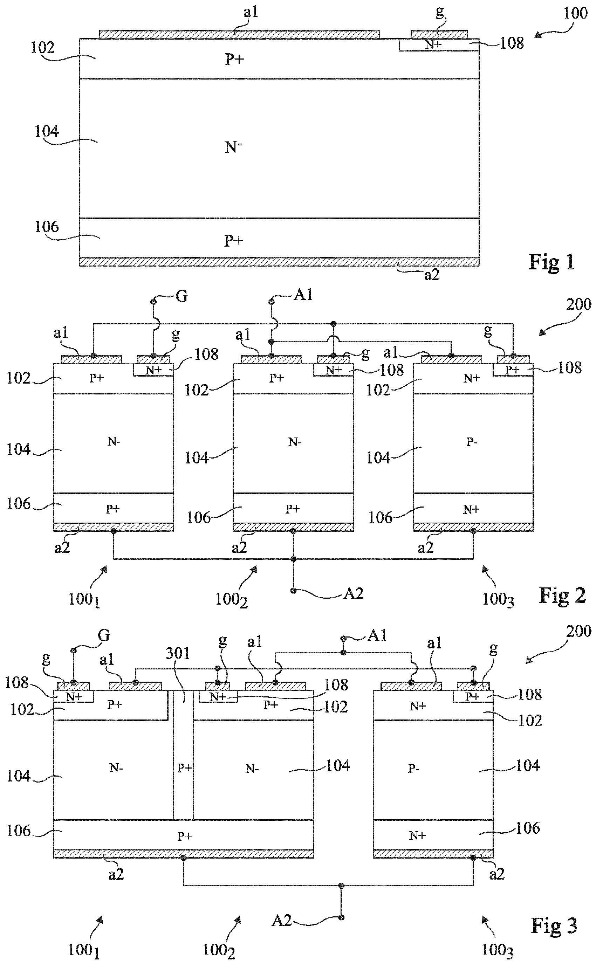

Un commutateur bidirectionnel de puissance commandable à l'état fermé et à l'état ouvert a par ailleurs récemment été proposé par la demanderesse dans l'article intitulé "A vertical bidirectional bipolar power switch (BipAC) for AC mains applications" de Hiba Rizk et al. La structure et le fonctionnement d'un tel commutateur seront décrits plus en détail ci-après en relation avec la figure 1.

Il existe un besoin pour un commutateur bidirectionnel de puissance commandable à l'état fermé et à l'état ouvert, ce commutateur palliant tout ou partie des inconvénients des commutateurs existants.

### Résumé

L'invention concerne un commutateur bidirectionnel de puissance selon la revendication 1.

Selon un mode de réalisation, les première, deuxième et troisième régions du premier composant sont respectivement de type P, N et P.

Selon un mode de réalisation, la surface semiconductrice du premier composant est inférieure à celle des deuxième et troisième composants.

Selon un mode de réalisation, les premier, deuxième et troisième composants sont formés respectivement dans trois puces semiconductrices distinctes.

Selon un mode de réalisation, les trois puces sont assemblées dans un même boîtier de protection.

Selon un mode de réalisation, les trois puces sont montées dans trois boîtiers de protection distincts.

Selon un mode de réalisation, les premier et deuxième composants d'une part, et le troisième composant d'autre part, sont formés respectivement dans deux puces semiconductrices distinctes assemblées dans un même boîtier de protection.

Selon un mode de réalisation, le boîtier de protection comprend trois bornes de connexion externes connectées respectivement aux première et deuxième bornes de conduction et à la borne de commande du commutateur.

Selon un mode de réalisation, les deuxièmes régions des premier et deuxième composants ont un niveau de dopage compris entre 7^{∗}10¹³ et 4^{∗}10¹⁴ atomes/cm³ et une épaisseur comprise entre 150 et 250 µm, et la deuxième région du troisième composant a un niveau de dopage compris entre 7^{∗}10¹³ et 4^{∗}10¹⁴ atomes/cm³ et une épaisseur comprise entre 150 et 250 µm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant de façon schématique un exemple d'un commutateur bidirectionnel de puissance ;
la figure 2 est une vue schématique d'un exemple d'un mode de réalisation d'un commutateur bidirectionnel de puissance ; et
la figure 3 est une vue schématique d'une variante de réalisation du commutateur bidirectionnel de puissance de la figure 2.

### Description détaillée

De mêmes éléments ont été désignés par de mêmes références aux différentes figures et, de plus, les diverses figures ne sont pas tracées à l'échelle. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, dans la pratique, les composants décrits peuvent être orientés différemment. Sauf précision contraire, les expressions "approximativement", "sensiblement", et "de l'ordre de" signifient à 20 % près, de préférence à 10 % près.

Dans la présente description, on entend par commutateur bidirectionnel de puissance un commutateur bidirectionnel en courant et en tension adapté à tenir des tensions relativement élevées à l'état ouvert, par exemple des tensions supérieures à 100 V et typiquement de l'ordre de 600 V ou plus. On s'intéresse ici plus particulièrement à un commutateur bidirectionnel de puissance commandable à l'état ouvert et à l'état fermé à partir d'une unique borne de gâchette référencée par rapport à l'une seulement de ses bornes principales ou bornes de conduction de puissance.

La figure 1 est une vue en coupe illustrant de façon schématique un exemple d'un commutateur bidirectionnel de puissance 100 du type décrit dans l'article de Hiba Rizk et al. susmentionné.

Le commutateur 100 est un composant monolithique comportant un empilement vertical de trois régions ou couches semiconductrices 102, 104 et 106 de types de conductivité alternés. Dans cet exemple, la région inférieure 106 est de type P, la région intermédiaire 104, s'étendant de la face supérieure de la région 106 à la face inférieure de la région 102, est de type N, et la région supérieure 102 est de type P. La région intermédiaire 104 est relativement peu dopée par rapport aux régions supérieure 102 et inférieure 106. Dans l'exemple représenté, la région intermédiaire 104 est plus épaisse que les régions supérieure 102 et inférieure 106. A titre d'exemple, le commutateur 100 est réalisé à partir d'un substrat semiconducteur faiblement dopé de type N, par exemple un substrat de silicium, les régions supérieure et inférieure 102 et 106 étant formées par implantation ou diffusion d'éléments dopants de type P respectivement depuis la face supérieure et depuis la face inférieure du substrat. Le commutateur 100 comprend en outre, dans une partie supérieure de la région supérieure 102, une région de commande 108 isolée de la région intermédiaire 104 par la région 102, de type de conductivité opposé à celui de la région 102 (c'est-à-dire de type N dans l'exemple représenté), et de niveau de dopage supérieur à celui de la région intermédiaire 104. La région de commande 108 s'étend, verticalement, depuis la face supérieure de la région 102 et sur une profondeur inférieure à celle de la région 102. En vue de dessus, la région de commande 108 occupe une partie seulement de la surface de l'empilement des régions 102, 104 et 106. A titre d'exemple, la région de commande 108 occupe (vu de dessus) moins de la moitié et de préférence moins du quart de la surface de l'empilement de régions 102, 104 et 106. Dans l'exemple représenté, la région de commande 108 est située le long d'un bord de l'empilement des régions 102, 104 et 106. La région 108 peut être formée (vu de dessus) de plusieurs zones, tel un transistor bipolaire de puissance classique dont les zones base et émetteur sont généralement inter-digitées. Le commutateur 100 comprend une première électrode principale ou électrode de conduction de puissance a1, en contact avec la face supérieure de la région 102 (au niveau de la portion de la région 102 non occupée par la couche 108). Le commutateur 100 comprend en outre une deuxième électrode principale ou électrode de conduction de puissance a2, en contact avec la face inférieure de la région 106. Le commutateur 100 comprend de plus une électrode de commande g en contact avec la face supérieure de la région de commande 108.

La mise en conduction (fermeture) du commutateur 100 de la figure 1 s'obtient en appliquant un courant négatif sur sa borne de commande g référencé par rapport à la borne a1, ce qui entraine la polarisation en direct de la jonction PN formée entre les régions 102 et 108. Des électrons de la région de commande 108 sont alors injectés dans la région 102. Une partie de ces électrons atteint la région 104, formant un courant de base entrainant la mise en conduction du transistor bipolaire vertical NPN formé par les régions 102, 104 et 106. Plus particulièrement, si la tension entre les bornes principales a1 et a2 du commutateur est positive (Va2-Va1 > 0, Va1 et Va2 désignant respectivement le potentiel de la borne a1 et le potentiel de la borne a2), des trous sont injectés depuis la région 106 dans la région 104. Une partie de ces trous est recombinée dans la région 104, le reste étant collecté par la région 102. Si la tension entre les bornes principales a1 et a2 est négative (Va2-Va1 < 0), des trous sont injectés depuis la région 102 dans la région 104. Une partie de ces trous est recombinée dans la région 104, le reste étant collecté par la région 106.

Le courant circulant dans le transistor PNP formé par les régions 102, 104 et 106 est fonction du courant de commande appliqué sur la borne de commande g.

L'ouverture du commutateur 100 s'obtient en interrompant le courant de commande appliqué sur la borne g, par exemple en mettant la borne g au même potentiel que la borne a1 ou en ouvrant la boucle de courant.

Comme indiqué dans l'article de Hiba Rizk et al. susmentionné, le gain de la structure de la figure 1, c'est-à-dire le rapport entre le courant circulant entre les électrodes principales a1 et a2 du commutateur à l'état passant, et le courant de commande appliqué sur l'électrode de commande g du commutateur, est d'autant plus élevé que l'épaisseur de la région de base 104 est faible. Toutefois, plus l'épaisseur de la région de base 104 est faible, moins la tenue en tension du commutateur est importante. Pour une épaisseur donnée de la région de base 104, le gain peut être augmenté en augmentant la surface de la partie active du commutateur (c'est-à-dire la partie de l'empilement PNP non occupée par la région de commande 108). Ceci entraine toutefois une augmentation significative du coût du commutateur. De plus, cette augmentation de gain est par construction limitée par le facteur de transport des porteurs de charge dans la région 104, qui a été évalué à environ 0,85 pour une tenue en tension de 600 V, ce qui correspond à un gain en courant maximum théorique de l'ordre de 5,6 pour des durées de vie des porteurs usuelles en régime de forte injection.

A titre d'exemple, avec une structure du type décrit en relation avec la figure 1, dimensionnée (niveaux de dopage et épaisseurs des couches 102, 104 et 106 en particulier) pour tenir une tension de 600 V et présentant une surface semiconductrice de l'ordre de 6 mm², et pour un courant de commande i_{g} de l'ordre de 40 mA, un gain environ égal à 4,5 a été mesuré pour une tension vₐ₂ₐ₁ (=Va2-Va1) entre les bornes de conduction a1 et a2 de l'ordre de 1 V, et un gain environ égal à 2,8 a été mesuré pour une tension Vₐ₂ₐ₁ de l'ordre de -1 V.

Il serait souhaitable de pouvoir améliorer le compromis entre le gain, la tenue en tension et la surface semiconductrice du commutateur. On notera en particulier qu'un gain élevé permet de limiter l'intensité du courant à appliquer sur la borne de commande du commutateur pour le rendre passant.

La figure 2 est une vue schématique d'un exemple d'un mode de réalisation d'un commutateur bidirectionnel de puissance 200.

Le commutateur 200 de la figure 2 comprend trois composants 100₁, 100₂ et 100₃ du type décrit en relation avec la figure 1. Dans l'exemple représenté, les composants 100₁ et 100₂ sont de même type de conductivité que le composant 100 de la figure 1, c'est-à-dire que leurs régions 102, 104, 106 et 108 sont respectivement de type P, de type N, de type P et de type N. Le composant 100₃ est de type de conductivité opposé, c'est-à-dire que ses régions 102, 104, 106 et 108 sont respectivement de type N, de type P, de type N et de type P. L'électrode principale a1 du composant 100₁ est connectée à l'électrode de commande g du composant 100₂ et à l'électrode de commande g du composant 100₃, par exemple par une piste ou un fil conducteur. L'électrode de commande g du composant 100₁ est connectée à une borne ou électrode de commande G du commutateur 200. L'électrode principale a1 du composant 100₂ et l'électrode principale a1 du composant 100₃ sont connectées à une première borne ou électrode principale A1 du commutateur 200. L'électrode principale a2 du composant 100₁, l'électrode principale a2 du composant 100₂ et l'électrode principale a2 du composant 100₃ sont connectées à une deuxième borne ou électrode principale A2 du commutateur 200.

Le commutateur 200 de la figure 2 peut être commandé de façon identique ou similaire au commutateur 100 de la figure 1, en remplaçant les bornes a1, a2 et g de la figure 1 par les bornes A1, A2 et G de la figure 2.

En particulier, la mise en conduction (fermeture) du commutateur 200 de la figure 2 s'obtient en appliquant un courant négatif sur sa borne de commande G en référence à sa borne A1, ce qui entraine la polarisation en direct de la jonction PN formée entre les régions 102 et 108 du composant 100₁.

Si la tension V_{A2A1} entre les bornes de conduction principales A1 et A2 du commutateur est positive, la jonction PN formée entre les régions 102 et 108 du composant 100₂ est polarisée en direct, et la tension V_{A2A1} est reportée entre les bornes a1 et a2 du composant 100₁ par l'intermédiaire de cette jonction (à la chute de tension de la jonction PN près). Sous l'effet du courant de commande négatif appliqué sur sa borne g, le composant 100₁ entre en conduction de façon identique ou similaire à ce qui a été décrit en relation avec la figure 1. Un courant circule alors entre les électrodes A1 et A2 du commutateur 200, ce courant passant par la jonction PN formée entre les régions 102 et 108 du composant 100₂, et par le transistor vertical PNP formé par les régions 102, 104 et 106 du composant 100₁. Ce courant constitue pour le composant 100₂ un courant de commande entrainant sa mise en conduction.

Si la tension V_{A2A1} entre les bornes de conduction principales A1 et A2 du commutateur est négative, la jonction PN formée entre les régions 108 et 102 du composant 100₃ est polarisée en direct, et la tension V_{A2A1} est reportée entre les bornes a1 et a2 du composant 100₁ par l'intermédiaire de cette jonction (à la chute de tension de la jonction PN près). Sous l'effet du courant de commande négatif appliqué sur sa borne g, le composant 100₁ entre en conduction de façon identique ou similaire à ce qui a été décrit en relation avec la figure 1. Un courant circule alors entre les électrodes A2 et A1 du commutateur 200, ce courant passant par le transistor vertical PNP formé par les régions 102, 104 et 106 du composant 100₁, et par la jonction PN formée entre la région 108 et la région 102 du composant 100₃. Ce courant constitue pour le composant 100₃ un courant de commande entrainant sa mise en conduction.

Ainsi, dans le commutateur 200 de la figure 2, le courant circule principalement dans le composant 100₂ lorsque la tension V_{A2A1} est positive, et dans le composant 100₃ lorsque la tension V_{A2A1} est négative. Le composant 100₁ permet d'amplifier le courant de commande des composants 100₂ et 100₃. Ainsi, le gain du commutateur 200 de la figure 2 est sensiblement égal au gain du composant 100₁ multiplié par le gain du composant 100₂ pour une tension V_{A2A1} positive, et au gain du composant 100₁ multiplié par le gain du composant 100₃ pour une tension V_{A2A1} négative.

On notera qu'en pratique, le composant 100₁ peut présenter une surface inférieure à celle des composants 100₂ et 100₃. Les modes de réalisation décrits ne se limitent toutefois pas à ce cas particulier. Plus généralement, quelles que soient les dimensions des composants 100₁, 100₂ et 100₃, le courant circulant entre les bornes A1 et A2 du commutateur 200 à l'état passant se répartit naturellement entre les composants 100₁ et 100₂ ou entre les composants 100₁ et 100₃ selon le sens de l'alternance, dans des proportions dépendant des dimensions des composants.

Un avantage du mode de réalisation décrit en relation avec la figure 2 est que, pour une tenue en tension donnée (définie notamment par l'épaisseur des régions 104 des composants 100₁, 100₂ et 100₃), il permet, au prix d'une augmentation raisonnable de la surface semiconductrice totale, d'augmenter significativement le gain par rapport à un commutateur du type décrit en relation avec la figure 1, et notamment d'augmenter le gain au-delà de la limite théorique imposée par le facteur de transport dans la région 104.

A titre d'exemple, avec une structure du type décrit en relation avec la figure 2, dimensionnée pour tenir une tension de 600 V et présentant une surface semiconductrice de l'ordre de 18 mm², et pour un courant de commande I_{G} de l'ordre de 40 mA, un gain environ égal à 12 a été mesuré pour une tension V_{A2A1} entre les bornes de conduction A1 et A2 de l'ordre de 1 V, et un gain environ égal à 11 a été mesuré pour une tension V_{A2A1} de l'ordre de -1 V.

Les composants 100₁, 100₂ et 100₃ du commutateur 200 de la figure 2 sont par exemple trois composants semiconducteurs discrets assemblés dans un même boîtier de protection comportant uniquement trois bornes de contact externes, les bornes A1, A2 et G. Les modes de réalisation décrits ne se limitent toutefois pas à ce cas particulier.

La figure 3 est une vue en coupe illustrant schématiquement une variante de réalisation du commutateur 200 de la figure 2, dans laquelle les composants 100₁ et 100₂ de même type de conductivité sont intégrés dans une même puce semiconductrice, le composant 100₃ étant quant à lui un composant discret formé dans une puce semiconductrice séparée. La puce comportant les composants 100₁ et 100₂ et la puce comportant le composant 100₃ peuvent être assemblées dans un même boîtier de protection comportant uniquement trois bornes de contact externes, les bornes A1, A2 et G.

Dans l'exemple de la figure 3, un mur vertical d'isolement 301 dopé de type P sépare le composant 100₁ du composant 100₂. Le mur d'isolement 301 est par exemple relié aux régions inférieures de type P 106 des composants 100₁ et 100₂. A titre d'exemple, le niveau de dopage du mur d'isolement 301 est le même que celui des régions inférieures de type P 106 des composants 100₁ et 100₂. Les régions supérieures de type P 102 des composants 100₁ et 100₂ sont isolées latéralement du mur 301 par des portions du substrat de type N 104.

A titre d'exemple, dans les modes de réalisation des figures 2 et 3, les régions 104 de type N des composants 100₁ et 100₂ peuvent avoir un niveau de dopage compris entre 7^{∗}10¹³ et 4^{∗}10¹⁴ atomes/cm³, la région 104 de type P du composant 100₃ peut avoir un niveau de dopage compris entre 7^{∗}10¹³ et 4^{∗}10¹⁴ atomes/cm³, les régions 102 de type P des composants 100₁ et 100₂ peuvent avoir un niveau de dopage compris entre 1^{∗}10¹⁶ et 1^{∗}10¹⁸ atomes/cm³, la région 102 de type N du composant 100₃ peut avoir un niveau de dopage compris entre 1^{∗}10¹⁶ et 1^{∗}10¹⁸ atomes/cm³, les régions 106 de type P des composants 100₁ et 100₂ peuvent avoir un niveau de dopage compris entre 1^{∗}10¹⁶ et 1^{∗}10¹⁸ atomes/cm³, la région 106 de type N du composant 100₃ peut avoir un niveau de dopage compris entre 1^{∗}10¹⁶ et 1^{∗}10¹⁸ atomes/cm³, les régions 108 de type N des composants 100₁ et 100₂ peuvent avoir un niveau de dopage compris entre 1^{∗}10¹⁹ et 1^{∗}10²⁰ atomes/cm³, et la région 108 de type P du composant 100₃ peut avoir un niveau de dopage compris entre 1^{∗}10¹⁹ et 1^{∗}10²⁰ atomes/cm³. De plus, les régions 104 de type N des composants 100₁ et 100₂ peuvent avoir une épaisseur comprise entre 150 et 250 µm, et la région 104 de type P du composant 100₃ peut avoir une épaisseur comprise entre 150 et 250 µm.

Des modes de réalisation particuliers ont été décrits. Diverses variantes et modifications apparaîtront à l'homme de l'art. En particulier, les modes de réalisation décrits ne se limitent pas aux exemples de valeurs numériques mentionnés dans la présente description.

De plus, un fonctionnement similaire a ce qui a été décrit ci-dessus peut être obtenu en inversant les types de conductivité des régions 102, 104, 106 et 108 des trois composants 100₁, 100₂ et 100₃.

## Revendications

1. Commutateur bidirectionnel de puissance (200) comportant des premier (100₁), deuxième (100₂) et troisième (100₃) composants comportant chacun :
un empilement de première (102), deuxième (104) et troisième (106) régions semiconductrices de types de conductivité alternés, les première (102), deuxième (104) et troisième (106) régions étant respectivement une région supérieure, une région intermédiaire et une région inférieure de l'empilement, la région intermédiaire s'étendant de la face supérieure de la région inférieure à la face inférieure de la région supérieure; et
une région semiconductrice de commande (108) de type de conductivité opposé à celui de la première région (102), disposée dans la première région (102) et ayant une surface et une profondeur inférieures, respectivement, à la surface et la profondeur de la première région,
dans lequel :
les premières régions (102) des premier (100₁) et deuxième (100₂) composants sont de même type de conductivité et les premières régions (102) des premier (100₁) et troisième (100₃) composants sont de types de conductivité opposés ;
la première région (102) du premier composant (100₁) est connectée aux régions de commande (108) des deuxième (100₂) et troisième (100₃) composants ;
les premières régions (102) des deuxième (100₂) et troisième (100₃) composants sont connectées à une première borne de conduction (A1) du commutateur ;
les troisièmes (106) régions des premier (100₁), deuxième (100₂) et troisième (100₃) composants sont connectées à une deuxième borne de conduction (A2) du commutateur ; et
la région de commande (108) du premier composant (100₁) est connectée à une borne de commande (G) du commutateur.

2. Commutateur (200) selon la revendication 1, dans lequel les première (102), deuxième (104) et troisième (106) régions du premier composant (100₁) sont respectivement de type P, N et P.

3. Commutateur (200) selon la revendication 1 ou 2, dans lequel la surface semiconductrice du premier composant (100₁) est inférieure à celle des deuxième (100₂) et troisième (100₃) composants.

4. Commutateur (200) selon l'une quelconque des revendications 1 à 3, dans lequel les premier (100₁), deuxième (100₂) et troisième (100₃) composants sont formés respectivement dans trois puces semiconductrices distinctes.

5. Commutateur (200) selon la revendication 4, dans lequel les trois puces sont assemblées dans un même boîtier de protection.

6. Commutateur (200) selon la revendication 4, dans lequel les trois puces sont montées dans trois boîtiers de protection distincts.

7. Commutateur (200) selon l'une quelconque des revendications 1 à 3, dans lequel les premier (100₁) et deuxième (100₂) composants d'une part, et le troisième composant (100₃) d'autre part, sont formés respectivement dans deux puces semiconductrices distinctes assemblées dans un même boîtier de protection.

8. Commutateur (200) selon la revendication 5 ou 7, dans lequel le boîtier de protection comprend trois bornes de connexion externes connectées respectivement aux première (A1) et deuxième (A2) bornes de conduction et à la borne de commande (G) du commutateur.

9. Commutateur (200) selon l'une quelconque des revendications 1 à 8, dans lequel les deuxièmes régions (104) des premier (100₁) et deuxième (100₂) composants ont un niveau de dopage compris entre 7^{∗}10¹³ et 4^{∗}10¹⁴ atomes/cm³ et une épaisseur comprise entre 150 et 250 µm, et la deuxième région (104) du troisième composant (100₃) a un niveau de dopage compris entre 7^{∗}10¹³ et 4^{∗}10¹⁴ atomes/cm³ et une épaisseur comprise entre 150 et 250 µm.

## Patentansprüche

1. Bidirektionaler Leistungsschalter (200) mit ersten (100₁), zweiten (100₂) und dritten (100₃) Komponenten, die jeweils Folgendes aufweisen:
einen Stapel von ersten (102), zweiten (104) und dritten (106) Halbleiterbereichen mit alternierenden Leitfähigkeitstypen, wobei die ersten (102), zweiten (104) und dritten (106) Bereiche ein oberer Bereich, ein Zwischenbereich bzw. ein unterer Bereich des Stapels sind, wobei sich der Zwischenbereich von der Oberseite des unteren Bereichs bis zur Unterseite des oberen Bereichs erstreckt; und
einen Halbleitersteuerbereich (108) mit einer Leitfähigkeitstyp, der dem des ersten Bereichs (102) entgegengesetzt ist, der in dem ersten Bereich (102) angeordnet ist und der eine Oberfläche und eine Tiefe aufweist, die niedriger ist als die jeweilige Oberfläche und Tiefe des ersten Bereichs,
wobei:
die ersten Bereiche (102) der ersten (100₁) und zweiten (100₂) Komponenten den gleichen Leitfähigkeitstyp aufweisen und die ersten Bereiche (102) der ersten (100₁) und dritten (100₃) Komponenten entgegengesetzte Leitfähigkeitstypen aufweisen;
der erste Bereich (102) der ersten Komponente (100₁) mit den Steuerbereichen (108) der zweiten (100₂) und dritten (100₃) Komponenten verbunden ist;
die ersten Bereiche (102) der zweiten (100₂) und dritten (100₃) Komponenten mit einem ersten Leitungsanschluss (A1) des Schalters verbunden sind;
die dritten (106) Bereiche der ersten (100₁), zweiten (100₂) und dritten (100₃) Komponenten mit einem zweiten Leitungsanschluss (A2) des Schalters verbunden sind; und
der Steuerbereich (108) der ersten Komponente (100₁) mit einem Steueranschluss (G) des Schalters verbunden ist.

2. Schalter (200) nach Anspruch 1, wobei die jeweiligen ersten (102), zweiten (104) und dritten (106) Bereiche der ersten Komponente (100₁) vom Typ P, N und P sind.

3. Schalter (200) nach Anspruch 1 oder 2, wobei die Halbleiteroberfläche der ersten Komponente (100₁) kleiner ist als die der zweiten (100₂) und dritten (100₃) Komponenten.

4. Schalter (200) nach einem der Ansprüche 1 bis 3, wobei die jeweiligen ersten (100₁), zweiten (100₂) und dritten (100₃) Komponenten in drei verschiedenen Halbleiterchips ausgebildet sind.

5. Schalter (200) nach Anspruch 4, wobei die drei Chips in einem gleichen Schutzgehäuse angeordnet sind.

6. Schalter (200) nach Anspruch 4, wobei die drei Chips in drei verschiedenen Schutzgehäusen angeordnet sind.

7. Schalter (200) nach einem der Ansprüche 1 bis 3, wobei die ersten (100₁) und zweiten (100₂) Komponenten einerseits und die dritte Komponente (100₃) andererseits jeweils als zwei verschiedenen Halbleiterchips ausgebildet sind, die in einem gleichen Schutzgehäuse angeordnet sind.

8. Schalter (200) nach Anspruch 5 oder 7, wobei das Schutzgehäuse drei jeweilige externe Anschlüsse aufweist, die mit den ersten (A1) und zweiten (A2) Leitungsschlüssen und mit dem Steueranschluss (G) des Schalters verbunden sind.

9. Schalter (200) nach einem der Ansprüche 1 bis 8, wobei die zweiten Bereiche (104) der ersten (100₁) und zweiten (100₂) Komponenten ein Dotierungsniveau im Bereich von 7^{∗}10¹³ bis 4^{∗}10¹⁴ Atome/cm³ und eine Dicke im Bereich von 150 bis 250 µm aufweisen und wobei der zweite Bereich (104) der dritten Komponente (100₃) ein Dotierungsniveau im Bereich von 7^{∗}10¹³ bis 4^{∗}10¹⁴ Atome/cm³ und eine Dicke im Bereich von 150 bis 250 µm aufweist.

## Claims

1. A bidirectional power switch (200) comprising first (100₁), second (100₂), and third (100₃) components, each comprising:
a stack of first (102), second (104), and third (106) semiconductor regions of alternated conductivity types, the first (102), the second (104) and the third (106) regions being respectively an upper region, an intermediate region and a lower region of the stack, the intermediate region extending from the upper surface of the lower region to the lower surface of the upper region; and
a semiconductor control region (108) having a conductivity type opposite to that of the first region (102), arranged in the first region (102) and having a surface and a depth lower, respectively, than the surface and the depth of the first region,
wherein:
the first regions (102) of the first (100₁) and second (100₂) components have the same conductivity type and the first regions (102) of the first (100₁) and third (100₃) components have opposite conductivity types;
the first region (102) of the first component (100₁) is connected to the control regions (108) of the second (100₂) and third (100₃) components;
the first regions (102) of the second (100₂) and third (100₃) components are connected to a first conduction terminal (A1) of the switch;
the third (106) regions of the first (100₁), second (100₂), and third (100₃) components are connected to a second conduction terminal (A2) of the switch; and
the control region (108) of the first component (100₁) is connected to a control terminal (G) of the switch.

2. The switch (200) of claim 1, wherein the first (102), second (104), and third (106) regions of the first component (100₁) respectively are of type P, N, and P.

3. The switch (200) of claim 1 or 2, wherein the semiconductor surface of the first component (100₁) is smaller than that of the second (100₂) and third (100₃) components.

4. The switch (200) of any of claims 1 to 3, wherein the first (100₁), second (100₂), and third (100₃) components are respectively formed in three different semiconductor chips.

5. The switch (200) of claim 4, wherein the three chips are assembled in a same protection package.

6. The switch (200) of claim 4, wherein the three chips are assembled in three different protection packages.

7. The switch (200) of any of claims 1 to 3, wherein the first (100₁) and second (100₂) components on the one hand, and the third component (100₃) on the other hand, are respectively formed in two different semiconductor chips assembled in a same protection package.

8. The switch (200) of claim 5 or 7, wherein the protection package comprises three external connection terminals respectively connected to the first (A1) and second (A2) conduction terminals and to the control terminal (G) of the switch.

9. The switch (200) of any of claims 1 to 8, wherein the second regions (104) of the first (100₁) and second (100₂) components have a doping level in the range from 7^{∗}10¹³ to 4^{∗}10¹⁴ atoms/cm³ and a thickness in the range from 150 to 250 µm, and the second region (104) of the third component (100₃) has a doping level in the range from 7^{∗}10¹³ to 4^{∗}10¹⁴ atoms/cm³ and has a thickness in the range from 150 to 250 µm.
